(19) Europäisches Patentamt
European Patent Office
Office européen des brevets

(11) **EP 4 354 528 B1**

(12) **EUROPEAN PATENT SPECIFICATION**

(45) Date of publication and mention
of the grant of the patent:
**17.06.2026  Bulletin 2026/25**

(21) Application number: **23199860.0**

(22) Date of filing: **26.09.2023**

(51) International Patent Classification (IPC):
*H01M 4/04* (2006.01)    *H01M 4/133* (2010.01)
*H01M 4/134* (2010.01)    *H01M 4/36* (2006.01)
*H01M 4/38* (2006.01)    *H01M 4/587* (2010.01)
*H01M 10/0525* (2010.01)    *H01M 4/505* (2010.01)
*H01M 4/525* (2010.01)    *H01M 4/02* (2006.01)

(52) Cooperative Patent Classification (CPC):
H01M 10/0525; H01M 4/0404; H01M 4/0435;
H01M 4/133; H01M 4/134; H01M 4/364;
H01M 4/366; H01M 4/386; H01M 4/505;
H01M 4/525; H01M 4/587; H01M 2004/021;
Y02E 60/10; Y02P 70/50

(54) **LITHIUM SECONDARY BATTERY**

LITHIUMSEKUNDÄRBATTERIE

BATTERIE SECONDAIRE AU LITHIUM

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **13.10.2022   KR 20220131766**

(43) Date of publication of application:
**17.04.2024   Bulletin 2024/16**

(60) Divisional application:
**26162098.3 / 4 760 792**

(73) Proprietor: **LG Energy Solution, Ltd.**
**Seoul 07335 (KR)**

(72) Inventors:
 • **PARK, Kyutae**
   **34122 DAEJEON (KR)**
 • **JUNG, Wonhee**
   **34122 DAEJEON (KR)**
 • **KIM, Minsoo**
   **34122 DAEJEON (KR)**
 • **KIM, Shulkee**
   **34122 DAEJEON (KR)**
 • **PIAO, Lilin**
   **34122 DAEJEON (KR)**
 • **BAEK, Sora**
   **34122 DAEJEON (KR)**
 • **YOO, Kwang Ho**
   **34122 DAEJEON (KR)**
 • **LEE, Gyeongseop**
   **34122 DAEJEON (KR)**

(74) Representative: **Plasseraud IP**
**104 Rue de Richelieu**
**CS92104**
**75080 Paris Cedex 02 (FR)**

(56) References cited:
   JP-B2- 6 676 289       US-A1- 2016 197 340
   US-A1- 2019 036 117    US-A1- 2021 013 493

 • "A Basic Guide to Particle Characterization",
   MALVERN INSTRUMENTS WORLDWIDE - WHITE
   PAPER, 2 May 2012 (2012-05-02), pages 1 - 26,
   XP055089322, Retrieved from the Internet
   <URL:http://golik.co.il/Data/
   ABasicGuidtoParticleCharacterization(2)
   _1962085150.pdf> [retrieved on 20190516]

**Description**

## TECHNICAL FIELD

The present invention relates to a lithium secondary battery.

## BACKGROUND ART

Secondary batteries are universally applied not only to portable devices but also to electric vehicles (EVs) and hybrid electric vehicles (HEVs), which are driven by electric driving sources.

Since such a secondary battery has not only the primary advantage of being able to dramatically reduce the use of fossil fuels, but also the advantage of not generating any by-products caused by the use of energy, the secondary battery is attracting attention as a new energy source that is environmentally friendly and improves energy efficiency.

In general, a secondary battery includes a positive electrode, a negative electrode, a separator interposed between the positive electrode and the negative electrode, an electrolyte, and the like. Further, an electrode such as a positive electrode and a negative electrode may have an electrode active material layer provided on a current collector.

As the utilization of secondary batteries increases, different battery performance characteristics are required. Although attempts have been appropriately made to change the composition of the electrode active material layer in order to improve battery performance or the sustainability thereof, some type of performance of the battery may be improved depending on the selection or combination of the material, but some other type of performance may rather deteriorate. For example, US2021013493 A1, JP6676289 B2 and US2029036117 A1, as well as US 2016/197340 A1, disclose positive and/or negative electrode compositions for secondary batteries. Therefore, there is a need for research on the selection or combination of materials suitable for of maintaining or improving the performance of a secondary battery while maintaining or improving the sustainability thereof.

## BRIEF DESCRIPTION OF THE INVENTION

The present invention has been made in an effort to provide a lithium secondary battery that has a high energy density and excellent service life characteristics, providing in this manner a secondary battery comprising more sustainable product characteristics.

An embodiment of the present invention provides a lithium secondary battery including: a positive electrode, a separator and a negative electrode,

in which the positive electrode comprises a lithium composite transition metal compound comprising nickel (Ni) and cobalt (Co);
the negative electrode comprises a silicon-based active material and a carbon-based active material;
wherein a and b are respectively the efficiency constants of the silicon-based active material and the carbon-based active material; c is the efficiency constant of the lithium composite transition metal compound; a* represents the parts by weight of the silicon-based active material based on 100 parts by weight of the total amount of the silicon-based active material and the carbon-based active material; and wherein a, a*, b, and c satisfy the following Equation 1:

$$[\text{Equation 1}]$$

$$[(a \times a^*) + \{b \times (100-a^*)\}] / c > 103.5$$

According to embodiments described in the present specification, a secondary battery with high energy density can be provided by selecting materials having excellent charge and discharge efficiency as active materials of a positive electrode and a negative electrode, and simultaneously, improved efficiency balance of the positive electrode and the negative electrode can be achieved by adjusting the efficiency constants and the contents of the active materials included in the positive electrode and the negative electrode so that the efficiency constants and the contents satisfy a specific equation, thereby improving the service life and quick charging performance of the battery, and accordingly the sustainability of the provided secondary battery.

## DETAILED DESCRIPTION

Hereinafter, the present invention will be described in more detail in order to help the understanding of the present invention. The present invention can be implemented in various different forms, and is not limited to the embodiments described herein. In this case, terms or words used in the specification and the claims should not be interpreted as being limited to typical or dictionary meanings.

In the present invention, the term "comprise", "include", or "have" is intended to indicate the presence of the characteristic, number, step, constituent element, or any combination thereof implemented, and should be understood to mean that the presence or addition possibility of one or more other characteristics or numbers, steps, constituent elements, or any combination thereof is not precluded.

When the term "about" is used, it may be referred to a value which may vary for example, $\pm 10\%$ of defined value, $\pm 5\%$ of the defined value, $\pm 1\%$ of the defined value, or $\pm 0.1\%$ of the defined value

A case where a part such as a layer is present "above" or "on" another part includes not only a case where the part is present "immediately above" another part, but also a case where still another part is present therebetween. Conversely, the case where a part is present "immediately above" another part means that no other part is present therebetween. In addition, a case of being "above" or "on" a reference part means being located above or below the reference part, and does not necessarily mean being located "above" or "on" in the opposite direction of gravity.

In the present specification, the 'primary particles' means particles having no grain boundaries in appearance when observed at a magnification of 5,000 times to 20,000 times using a scanning electron microscope.

In the present specification, the 'secondary particles' are particles formed by aggregation of primary particles.

In the present specification, single particle is a term used to distinguish single particles from positive electrode active material particles in the form of secondary particles. Secondary particles are formed by aggregation of a plurality (for example, more than 50 or hundreds) of primary particles generally as described herein. On the other hand, the concept of single particle refers to a particle composed of one primary particle or composed by an aggregate of 50 or less primary particles, for example 20 or less primary particles, or for example 10 or less primary particles.

In the present specification, the 'particles' may be meant to include any one or all of single particles, secondary particles, and primary particles.

A lithium secondary battery according to an embodiment of the present invention includes a positive electrode, a separator and a negative electrode, according to the independent claim 1.

The value of Equation 1 may be calculated as a value up to one decimal place.

The present inventors recognized that high-efficiency positive and negative materials with good charging/-discharging efficiency need to used in order to achieve a high energy density of a battery. However, the use of a silicon-based active material having a large capacity per weight as a negative electrode material, may induce the deterioration of the negative electrode, and accordingly, long-term service life characteristics may also deteriorate. Thus, the present inventors found that the long service life can be influenced by adjusting the efficiency balance between the positive electrode and the negative electrode, by using simultaneously a highly efficient silicon-based active material as a negative electrode active material and a lithium-nickel-cobalt-based compound as a positive electrode active material, while also satisfying a specific efficiency parameter, . Specifically, when the above-described components included in the positive electrode and the negative electrode satisfy Equation 1, a high-energy density battery may be provided, and simultaneously the efficiency balance between the positive electrode and the negative electrode may be improved thereby preventing the deterioration of the initial negative electrode and significantly improving the service life characteristics thereof.

According to an embodiment, the silicon-based active material may be a silicon-carbon composite or silicon oxide and may optionally comprise crystalline silicon, whereas the carbon-based active material may be graphite. The lithium composite transition metal compound including nickel (Ni) and cobalt (Co) may be a single particle.

According to an embodiment, the lithium composite transition metal compound including nickel (Ni) and cobalt (Co) may include 80 mol% or more, for example, 80 mol% or more and less than 100 mol% of nickel referred to the total mols of nickel, cobalt and of any additional metal M of the lithium composite transition metal compound excluding lithium. When the nickel content is high as described above, the positive electrode efficiency may be increased to implement the high energy density of a battery.

According to the present invention, the lithium composite transition metal compound comprises metals lithium (Li), nickel (Ni) and cobalt (Co) and, optionally it may also comprise one or more additional metal M. For example, the one or more additional metals is selected from the group consisting of Mn, Al, Ba, Ca, Zr, Ti, Mg, Ta, Nb and Mo.

Thus, when the lithium composite transition metal compound does not comprise any metal M in addition to lithium (Li), nickel (Ni) and cobalt (Co), the lithium composite transition metal compound including nickel (Ni) and cobalt (Co) may include 80 mol% or more, for example, 80 mol% or more and less than 100 mol% of nickel (Ni), being said percentage referred to the sum of mols of nickel (Ni) and cobalt (Co). On the other hand, when the lithium composite transition metal compound comprises one or more metals M in addition to lithium (Li), nickel (Ni) and cobalt (Co), the lithium composite transition metal compound including nickel (Ni) and cobalt (Co) may include 80 mol% or more, for example, 80 mol% or more and less than 100 mol% of nickel (Ni), being said percentage referred to the sum of mols of nickel (Ni), cobalt (Co) and the one or more metals M present in addition to lithium (Li), nickel (Ni) and cobalt (Co).

According to an embodiment, the lithium composite transition metal compound including nickel (Ni) and cobalt (Co) may further include at least one metal M1 selected from the group consisting of manganese and aluminum.

Specifically, the lithium composite transition metal compound including nickel (Ni) and cobalt (Co) may be represented by the following Chemical Formula 1.

[Chemical Formula 1] $\quad\quad Li_aNi_{(1-x-y)}Co_xM1_yM2_wO_2$

In Chemical Formula 1,

$1.0 \leq a \leq 1.5$, $0 \leq x \leq 0.2$, $0 \leq y \leq 0.2$, $0 \leq w \leq 0.1$, $0 \leq x+y \leq 0.2$,
M1 is at least one metal selected from the group consisting of Mn and Al, and
M2 is one or more metal elements selected from the group consisting of Ba, Ca, Zr, Ti, Mg, Ta, Nb and Mo.

The average particle diameter (D50) of the lithium composite transition metal compound is 12 $\mu$m to 30 $\mu$m, for example, 13 $\mu$m to 28 $\mu$m, 15 $\mu$m to 25 $\mu$m, 17 $\mu$m to 23 $\mu$m. The BET specific surface area of the lithium composite transition metal compound is 0.5 m2/g to 1.1 m$^2$/g, such as 0.6 m2/g to 1 m$^2$/g, or 0.7 m2/g to 0.9 m$^2$/g. The composition ratio, average particle diameter (D50), BET surface area, etc. of the lithium composite transition metal compound affect the efficiency constant c of the lithium composite transition metal compound.

According to an embodiment, the positive electrode may include 90 parts by weight to 100 parts by weight of the lithium composite transition metal compound including nickel (Ni) and cobalt (Co), for example more than 92 parts by weight, more than 94 parts by weight, more than 96 parts by weight, more than 98 parts by weight, or between 98 parts by weight to 100 parts by weight, based on 100 parts by weight of the positive electrode active material.

In the present specification, the silicon carbon composite is a composite of Si and C, may also be represented by a Si/C-based active material, and is distinguished from silicon carbide represented by SiC. The silicon carbon composite may be a composite of silicon, graphite, , and may also form a structure in which a core of silicon and graphite composite is surrounded by graphene, amorphous carbon. In the silicon carbon composite, the silicon may be nano-silicon, which is a nano-sized particle of silicon dispersed in the silicon carbon composite.

The silicon oxide may be termed as $SiO_x$ ($0 \leq x < 2$) and may be a silicon-based composite particle including $SiO_x$ ($0 < x < 2$) and pores.

According to the present disclosure, the term composite particle, when referred to particles of a silicon-based active material, refers to particles comprising a silicon-based active material composite, optionally other elements or compounds, and pores.

According to the present disclosure, a composite refers to two or more materials which are physically aggregated but not chemically bonded.

The silicon-based composite particle comprises a $SiO_x$ ($0 < x < 2$) matrix including Si and $SiO_2$, wherein the Si may also form a separate phase and may be crystalline Si. That is, the x corresponds to the number ratio of O for Si included in the $SiO_x$ ($0 < x < 2$).

The silicon-based active material may have an average particle diameter ($D_{50}$) of 2 $\mu$m to 15 $\mu$m, specifically 3 $\mu$m to 13 $\mu$m, and more specifically 4 $\mu$m to 12 $\mu$m. When the above range is satisfied, side reactions between the silicon-based composite particles and an electrolyte solution may be controlled, and the discharge capacity and initial efficiency of the battery may be effectively implemented. Additionally, the size of Si crystal grains (i.e. crystalline Si) included in the silicon-based active material may be 10 nm to 30 nm, for example, 15 nm to 25 nm

The composition ratio of the elements constituting the silicon-based active material, the presence or type of a coating layer on the particle surface, the average particle diameter (D50), the size of Si crystal grains, etc. affect the efficiency constant a of the silicon-based active material.

In the present specification, an average particle diameter ($D_{50}$) may be defined as a particle diameter corresponding to 50% of a cumulative volume in a particle diameter distribution curve of the particles. The average particle diameter ($D_{50}$) may be measured using, for example, a laser diffraction method. The laser diffraction method can generally measure a particle diameter of about several mm from the submicron region, and results with high reproducibility and high resolution may be obtained.

In the present specification, the "crystal grain size" may be quantitatively analyzed using X-ray diffraction analysis (XRD) by Cu K$\alpha$ X-rays.

In the present specification, a "specific surface area" is measured by a BET method, specifically, may be measured by degassing for 2 hours at 130°C using a BET measuring device (BEL-SORP-mini, Nippon Bell) for a measured object and performing $N_2$ absorption/desorption at 77 K.

According to an embodiment, the silicon-based active material has a discharge efficiency of 85% to 95%, for example 87% to 93%, 89% to 91%, or for example 85% to 90%, or 90% to 95%.

The charge capacity and discharge capacity of the negative electrode and positive electrode active materials may be measured as follows.

First, the active material, a Super-C™ conductive material : a carboxymethyl cellulose (CMC) thickener : a styrene-butadiene rubber (SBR) binder polymer are added to water at a weight ratio of 95 : 1 : 1 : 3 to prepare a slurry, and a copper foil is coated with the slurry, punched and rolled so as to have an area of 1.4875 cm$^2$, and then dried to manufacture an electrode. An electrode assembly is manufactured by using lithium metal as a counter electrode together with the electrode and interposing a polypropylene separator therebetween. After 1 M LiPF$_6$ is added to an organic solvent so as to have a concentration of 1 wt% by mixing ethylene carbonate and ethylmethyl carbonate at a volume ratio of 3:7 and adding vinylene carbonate to prepare a non-aqueous electrolyte solution, a coin half cell (CHC) is manufactured by injecting the non-aqueous electrolyte solution into the electrode assembly.

After the coin half cell (CHC) manufactured above is charged, a constant current of 0.005 V is applied at a rate of 0.2 C using a constant current constant voltage (CC-CV) method, and then the current is controlled with a constant voltage of 0.005 V. During discharge, the discharge efficiency may be measured by cutting-off at 1.5V using a constant current (CC) method at a rate of 0.2 C.

The efficiency constant a of a silicon-based active material is defined as the percentage ratio of the discharge capacity to the charge capacity measured using a silicon-based active material as the negative electrode active material, that is, [discharge capacity (silicon-based) /charge capacity (silicon-based) *100] .

The efficiency constant b of a carbon-based active material, is defined as the percentage ratio of the discharge capacity and charge capacity measured using a carbon-based active material as the negative electrode active material, that is, [discharge capacity $_{(carbon-based)}$/charge capacity (carbon-based) *100] .

The efficiency constant c of lithium composite transition metal compound including nickel (Ni) and cobalt (Co), is defined as the percentage ratio of the discharge capacity and the charge capacity measured using a positive electrode active material as the active material, that is, [discharge capacity$_{(nickel-cobalt-based)}$/charge capacity (nickel-cobalt-based) *100].

According to the invention, a is 70 to 85, such as 75 to 80, b is 85 to 98, such as 90 to 95, and c is 85 to 90, such as 86 to 89.

According to the invention, the silicon-based active material is included in an amount of 1 part by weight to 20 parts by weight, for example 2 parts by weight to 18 parts by weight, 3 parts by weight to 15 parts by weight, 4 parts by weight to 10 parts by weight, 5 parts by weight to 7 parts by weight, based on 100 parts by weight of the negative electrode active material. According to the invention, the silicon-based active material is included in an amount of 1 part by weight to 20 parts by weight, for example 2 parts by weight to 18 parts by weight, 5 parts by weight to 15 parts by weight, based on 100 parts by weight of the total amount of the silicon-based active material and the carbon-based active material. Keeping a content of the silicon-based active material of 1 wt% or more, may allow obtaining a capacity gain equal to or more than a certain level, and there may be an advantage of using the materials, and when the content is 20 wt% or less, excessive swelling is prevented which may be advantageous in terms of service life and battery characteristics and be price-competitive in terms of costs.

According to an embodiment, the graphite included in the negative electrode may be natural graphite, artificial graphite or a mixture thereof. The graphite may be included in an amount of 80 parts by weight or more and 99 parts by weight or less, for example 85 parts by weight to 98 parts by weight, 87 parts by weight to 97 parts by weight, 92 parts by weight to 96 parts by weight, based on 100 parts by weight of the active material included in the negative electrode. When the graphite includes both artificial graphite and natural graphite, the content ratio of artificial graphite to natural graphite may be 5:5 to 9:1, for example, 6:4 to 8:2, or 7:3. The average particle diameter (D50) of artificial graphite may be 5 μm to 20 μm, for example 6 μm to 18 μm, or 7 μm to 15 μm, or 8 μm to 12 μm, and the average particle diameter (D50) of natural graphite may be 5 μm to 30 μm, for example 7 μm to 28 μm, or 10 μm to 27 μm, or 12 μm to 26 μm, or 15 μm to 25 μm.

According to an embodiment, the negative electrode may include a current collector; and a negative electrode active material layer provided on the current collector.

The negative electrode active material based on 100 parts by weight of the negative electrode active material layer may be included in an amount of 80 parts by weight or more and 99.9 parts by weight or less, for example from 88 parts by weight to 98 parts by weight, from 92 parts by weight to 97 parts.

In some embodiments, the negative electrode active material layer may comprise other ingredients or compounds, such as a binder or a conductive material, in addition to the negative active materials. According to an embodiment of the present specification, the negative electrode active material layer may further include a negative electrode binder in addition to the silicon-based active material and the carbon-based active material.

The negative electrode binder may serve to improve the bonding between negative electrode active material particles and the adhesion between the negative electrode active material particles and the negative electrode current collector. As the negative electrode binder, those known in the art may be used, and non-limiting examples thereof may include at least one selected from the group consisting of a polyvinylidene fluoride-hexafluoropropylene copolymer (PVDF-co-HFP), polyvinylidene fluoride, polyacrylonitrile, polymethylmethacrylate, polyvinyl alcohol, carboxymethyl cellulose (CMC), starch, hydroxypropyl cellulose, regenerated cellulose, polyvinylpyrrolidone, tetrafluoroethylene, polyethylene, polypropylene, polyacrylic acid, an ethylene-propylene-diene monomer (EPDM), a sulfonated EPDM, styrene

butadiene rubber (SBR), fluorine rubber, polyacrylic acid and a material in which the hydrogen thereof is substituted with Li, Na, Ca, or the like, and may also include various copolymers thereof.

The negative electrode binder may be included in an amount of 0.1 parts by weight or more and 20 parts by weight or less, 0.2 parts by weight or more or 18 parts by weight or less, 0.3 parts by weight or more or 16 parts by weight or less, 0.4 parts by weight or more or 14 parts by weight or less, 0.5 parts by weight or more or 12 parts by weight or less, 0.6 parts by weight or more or 10 parts by weight or less, for example, preferably 0.3 parts by weight or more and 20 parts by weight or less, and more preferably 0.5 parts by weight or more and 10 parts by weight or less, based on 100 parts by weight of the negative electrode active material layer.

The negative electrode active material layer may not include a conductive material, but may further include a conductive material, if necessary. The conductive material included in the negative electrode active material layer is not particularly limited as long as the conductive material has electrical conductivity without causing a chemical change to the battery, and for example, it is possible to use graphite such as natural graphite or artificial graphite; carbon black such as acetylene black, Ketjen black, channel black, furnace black, lamp black, and thermal black; a conductive fiber such as carbon fiber or metal fiber; a conductive tube such as a carbon nanotube; a metal powder such as a fluorocarbon powder, an aluminum powder, and a nickel powder; a conductive whisker such as zinc oxide and potassium titanate; a conductive metal oxide such as titanium oxide; a conductive material such as polyphenylene derivatives, and the like. The content of the conductive material in the negative electrode active material layer may be 0.01 parts by weight to 20 parts by weight, 0.05 parts by weight to 18 parts by weight, 0.10 parts by weight to 16 parts by weight, 0.50 parts by weight to 14 parts by weight, 1.50 parts by weight to 12 parts by weight, 3 parts by weight to 10 parts by weight, 5 parts by weight to 8 parts by weight, preferably 0.03 parts by weight to 18 parts by weight, based on 100 parts by weight of the negative electrode active material layer.

For the purposes of the present disclosure, when the carbon-based active material is graphite, such as natural graphite or artificial graphite, the parts by weight of the graphite used as carbon-based active material are not to be taken into consideration when defining the total parts by weight of conductive material. In an analogous manner, when the conductive material selected according for the negative electrode is graphite, the parts by weight of conductive material described are not to be included when defining the total parts by weight of carbon-based negative electrode active material. Accordingly, when graphite is selected both as carbon-based negative electrode active material and as negative electrode conductive material, the total parts by weight of graphite correspond to the addition of the parts by weight of graphite used as carbon-based negative electrode active material and of the parts by weight of graphite used as negative electrode conductive material.

The conductive material included in the negative electrode active material layer is, for example, carbon black such as acetylene black, Ketjen black, channel black, furnace black, lamp black, and thermal black; a conductive fiber such as carbon fiber or metal fiber; a conductive tube such as a carbon nanotube.

In an embodiment of the present specification, the negative electrode active material layer may have a thickness of 5 $\mu$m or more and 500 $\mu$m or less, 20 $\mu$m or more and 400 $\mu$m or less, 50 $\mu$m or more and 300 $\mu$m or less, 100 $\mu$m or more and 200 $\mu$m or less.

In an embodiment of the present application, the negative electrode current collector is sufficient as long as the negative electrode current collector has electrical conductivity without causing a chemical change to the battery, and is not particularly limited. For example, as the current collector, it is possible to use copper, stainless steel, aluminum, nickel, titanium, fired carbon, or aluminum or stainless steel whose surface is treated with carbon, nickel, titanium, silver, and the like. Specifically, a transition metal, such as copper or nickel which adsorbs carbon well, may be used as a current collector. Although the current collector may have a thickness of 1 $\mu$m to 50 $\mu$m, for example 2 $\mu$m to 40 $\mu$m, 5 $\mu$m to 30 $\mu$m, 10 $\mu$m to 20 $\mu$m, the thickness of the current collector is not limited thereto.

In an embodiment of the present specification, the positive electrode includes a positive electrode current collector and a positive electrode active material layer formed on the positive electrode current collector and including a lithium composite transition metal compound which includes nickel (Ni) and cobalt (Co). The positive electrode active material layer may have a thickness of 20 $\mu$m or more and 500 $\mu$m or less, 30 $\mu$m or more and 400 $\mu$m or less, 50 $\mu$m or more and 300 $\mu$m or less, 100 $\mu$m or more and 200 $\mu$m or less.

The positive electrode current collector is not particularly limited as long as the collector has electrical conductivity without causing a chemical change to a battery, and for example, it is possible to use stainless steel, aluminum, nickel, titanium, calcined carbon, or aluminum or stainless steel whose surface is treated with carbon, nickel, titanium, silver, and the like. Further, the positive electrode current collector may typically have a thickness of 1 to 50 $\mu$m, for example 2 $\mu$m to 40 $\mu$m, 5 $\mu$m to 30 $\mu$m, 10 $\mu$m to 20 $\mu$m, and the adhesion of the positive electrode active material may also be enhanced by forming fine irregularities on the surface of the current collector. For example, the positive electrode current collector may be used in various forms such as a film, a sheet, a foil, a net, a porous body, a foam body, and a non-woven fabric body.

In an embodiment, the positive electrode active material in 100 parts by weight of the positive electrode active material layer may be included in an amount of 80 parts by weight or more and 99.9 parts by weight or less, for example from 80 parts by weight to 98 parts by weight, from 85 parts by weight to 95 parts by weight, preferably 90 parts by weight or more and 99.9 parts by weight or less, more preferably 95 parts by weight or more and 99.9 parts by weight or less.

According to an additional embodiment of the present specification, the positive electrode active material layer may further include a positive electrode binder and a conductive material.

The positive electrode binder may serve to improve the bonding between positive electrode active material particles and the adhesion between the positive electrode active material particles and the positive electrode current collector. As the positive electrode binder, those known in the art may be used, non-limiting examples thereof include polyvinylidene fluoride (PVDF), a vinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, tetrafluoroethylene, polyethylene, polypropylene, an ethylene-propylene-diene monomer (EPDM), a sulfonated EPDM, styrene-butadiene rubber (SBR), fluorine rubber, or various copolymers thereof, and any one thereof or a mixture of two or more thereof may be used.

The positive electrode binder may be included in an amount of 0.1 parts by weight or more and 20 parts by weight or less, for example, preferably 0.3 parts by weight or more and 35 parts by weight or less, and more preferably 0.5 parts by weight or more and 20 parts by weight or less, based on 100 parts by weight of the positive electrode active material layer.

The conductive material included in the positive electrode active material layer is used to impart electrical conductivity to the electrode, and can be used without particular limitation as long as the conductive material has electrical conductivity without causing a chemical change in a battery. Specific examples thereof include graphite such as natural graphite or artificial graphite; a carbon-based material such as carbon black, acetylene black, Ketjen black, channel black, furnace black, lamp black, thermal black, and carbon fiber; metal powder or metal fiber such as copper, nickel, aluminum, and silver; a conductive whisker such as zinc oxide and potassium titanate; a conductive metal oxide such as titanium oxide; or a conductive polymer such as a polyphenylene derivative, and any one thereof or a mixture of two or more thereof may be used.

Specifically, the conductive material may include one or more of a single-walled carbon nanotube (SWCNT); and a multi-walled carbon nanotube (MWCNT). The conductive material may be included in an amount of 0.1 parts by weight or more and 2 parts by weight or less, for example, preferably 0.3 parts by weight or more and 1.5 parts by weight or less, and more preferably 0.5 parts by weight or more and 1.2 parts by weight or less, based on 100 parts by weight of the composition for a positive electrode active material layer.

The positive electrode and the negative electrode may be manufactured by a method for manufacturing a positive electrode and a negative electrode in the related art, except that the aforementioned positive electrode and negative electrode active materials are used. Specifically, after a composition for forming an active material layer, which includes the aforementioned active material and, optionally, a binder and a conductive material is applied onto current collectors, the positive electrode and negative electrode may be manufactured by drying and rolling the current collectors.

One embodiment refers to a method of manufacturing a secondary battery according to the present specification, said method comprising:

applying a positive electrode active material layer comprising a lithium composite transition metal compound comprising nickel (Ni) and cobalt (Co) onto a positive electrode current collector to obtain a positive electrode;
applying a negative electrode active material layer comprising a silicon-based active material and a carbon-based active material onto a negative electrode current collector to obtain a negative electrode;
drying and rolling the positive and negative electrodes;
stacking positive electrode and negative electrode were stacked a separator interposed therebetween;
wherein a and b are respectively the efficiency constants of the silicon-based active material and the carbon-based active material; c is the efficiency constant of the lithium composite transition metal compound; a* represents the parts by weight of the silicon-based active material based on 100 parts by weight of the total amount of the silicon-based active material and the carbon-based active material, and
wherein a, a*, b, and c satisfy the following Equation 1:

[Equation 1]

$$[(a \times a^*) + \{b \times (100-a^*)\}] / c > 103.5.$$

The types and contents of the positive and negative active materials, binders, and conductive materials are as described above. The solvent may be a solvent commonly used in the art, examples thereof include dimethyl sulfoxide (DMSO), isopropyl alcohol, N-methylpyrrolidone (NMP), acetone, water, or the like, and among them, any one thereof or a mixture of two or more thereof may be used. The amount of solvent used is sufficient as long as the solvent in the amount dissolves or disperses the active material, conductive material and binder in consideration of the application thickness and preparation yield of the slurry, and has a viscosity capable of exhibiting excellent thickness uniformity during subsequent application for manufacturing the positive electrode and the negative electrode. Alternatively, by another method, the positive electrode and the negative electrode may be manufactured by casting the composition for forming an active material layer on a separate support and then laminating a film obtained by performing peel-off from the support on a current collector.

The separator separates the negative electrode and the positive electrode and provides a passage for movement of lithium ions, and can be used without particular limitation as long as the separator is typically used as a separator in a secondary battery, and in particular, a separator having an excellent ability to retain moisture of an electrolytic solution as well as low resistance to ion movement in the electrolyte is preferable. Specifically, it is possible to use a porous polymer film, for example, a porous polymer film formed of a polyolefin-based polymer such as an ethylene homopolymer, a propylene homopolymer, an ethylene/butene copolymer, an ethylene/hexene copolymer, and an ethylene/methacrylate copolymer, or a laminated structure of two or more layers thereof. In addition, a typical porous non-woven fabric, for example, a non-woven fabric made of a glass fiber having a high melting point, a polyethylene terephthalate fiber, and the like may also be used. Furthermore, a coated separator including a ceramic component or a polymeric material may be used to secure heat resistance or mechanical strength and may be selectively used as a single-layered or multi-layered structure.

Examples of the electrolyte include an organic liquid electrolyte, an inorganic liquid electrolyte, a solid polymer electrolyte, a gel-type polymer electrolyte, a solid inorganic electrolyte, a molten-type inorganic electrolyte, and the like, which can be used in the preparation of a lithium secondary battery, but are not limited thereto.

Specifically, the electrolyte may include a non-aqueous organic solvent and a metal salt.

As the non-aqueous organic solvent, it is possible to use, for example, an aprotic organic solvent, such as N-methyl-2-pyrrolidinone, propylene carbonate, ethylene carbonate, butylene carbonate, dimethyl carbonate, diethyl carbonate, $\gamma$-butyrolactone, 1,2-dimethoxy ethane, tetrahydrofuran, 2-methyl tetrahydrofuran, dimethyl sulfoxide, 1,3-dioxolane, formamide, dimethylformamide, dioxolane, acetonitrile, nitromethane, methyl formate, methyl acetate, phosphate triester, trimethoxy methane, a dioxolane derivative, sulfolane, methyl sulfolane, 1,3-dimethyl-2-imidazolidinone, a propylene carbonate derivative, a tetrahydrofuran derivative, ether, methyl propionate, and ethyl propionate.

In particular, among the carbonate-based organic solvents, cyclic carbonates ethylene carbonate and propylene carbonate may be preferably used because the cyclic carbonates have high permittivity as organic solvents of a high viscosity and thus dissociate a lithium salt well, and such cyclic carbonates may be more preferably used since the cyclic carbonate may be mixed with a linear carbonate of a low viscosity and low permittivity such as dimethyl carbonate and diethyl carbonate in an appropriate ratio and used to prepare an electrolyte having a high electrical conductivity.

As the metal salt, a lithium salt may be used, the lithium salt is a material which is easily dissolved in the non-aqueous electrolyte solution, and for example, as an anion of the lithium salt, it is possible to use one or more selected from the group consisting of F-, Cl-, I-, $NO_3$-, $N(CN)_2$-, $BF_4$-, $ClO_4$-, $PF_6$-, $(CF_3)_2PF_4$-, $(CF_3)_3PF_3$-, $(CF_3)_4PF_2$-, $(CF_3)_5PF$-, $(CF_3)_6P$-, $CF_3SO_3$-, $CF_3CF_2SO_3$-, $(CF_3SO_2)_2N$-, $(FSO_2)_2N$-, $CF_3CF_2(CF_3)_2CO$-, $(CF_3SO_2)_2CH$-, $(SF_5)_3C$-$(CF_3SO_2)_3C$-, $CF_3(CF_2)_7SO_3$-, $CF_3CO_2$-, $CH_3CO_2$-, SCN- and $(CF_3CF_2SO_2)_2N$-.

For the purposes of improving the service life characteristics of a battery, suppressing the decrease in battery capacity, and improving the discharge capacity of the battery, thereby improving the sustainability of the battery, one or more additives may be further included in addition to the above electrolyte constituent components, such as, for example, a halo-alkylene carbonate-based compound such as difluoroethylene carbonate, pyridine, triethylphosphite, triethanolamine, cyclic ether, ethylenediamine, n-glyme, hexaphosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol, or aluminum trichloride.

A lithium secondary battery according to an embodiment of the present invention includes an assembly including a positive electrode, a negative electrode, a separator and an electrolyte.

An additional embodiment of the present invention provides a positive electrode slurry of a lithium secondary battery according to the embodiments of the present invention, the slurry comprising at least 90 parts by weight of a lithium composite transition metal compound comprising nickel (Ni) and cobalt (Co), for example more than 92 parts by weight, more than 94 parts by weight, more than 96 parts by weight, more than 98 parts by weight, or between 98 parts by weight to 100 parts by weight, based on 100 parts by weight of the positive electrode active material,

wherein the lithium composite transition metal compound comprising nickel (Ni) and cobalt (Co) has an average particle diameter ($D_{50}$) of 12 $\mu$m to 30 $\mu$m, for example, 13 $\mu$m to 28 $\mu$m, 15 $\mu$m to 25 $\mu$m, 17 $\mu$m to 23 $\mu$m, and a BET of 0.5 m2/g to 1.1 $m^2$/g, such as 0.6 m2/g to 1 $m^2$/g, or 0.7 $m^2$/g to 0.9 $m^2$/g, and with an efficiency constant c of 85 to 90, such as 86 to 89.

An additional embodiment of the present invention provides a negative electrode slurry of a lithium secondary battery according to the embodiments of the present invention, the slurry comprising at least 1 part by weight of a silicon-based active material and at least 80 parts by weight of a carbon-based active material, based on 100 parts by weight of the negative electrode active material;

wherein the silicon-based active material is a silicon-carbon composite or silicon oxide with an efficiency constant a of 70 to 85, such as 75 to 80, and the carbon-based active material is graphite with an efficiency constant b of 85 to 98, such as 90 to 95; the graphite including both artificial graphite and natural graphite in a ratio of artificial graphite to natural graphite of 5:5 to 9:1, for example, 6:4 to 8:2, or 7:3; and wherein the average particle diameter ($D_{50}$) of artificial graphite is 5 $\mu$m to 20 $\mu$m, for example 6 $\mu$m to 18 $\mu$m, or 7 $\mu$m to 15 $\mu$m, or 8 $\mu$m to 12 $\mu$m, and the average particle diameter ($D_{50}$) of natural graphite is 5 $\mu$m to 30 $\mu$m, for example 7 $\mu$m to 28 $\mu$m, or 10 $\mu$m to 27 $\mu$m, or 12 $\mu$m to 26 $\mu$m, or 15 $\mu$m to 25 $\mu$m.

According to an embodiment of the present invention, the positive or negative electrode slurries disclosed herein further comprise one or more of a binder and a conductive material according to the embodiments of the present invention.

An additional embodiment of the present invention provides a battery module including the above-described lithium secondary battery as a unit cell and a battery pack including the same. The battery module and the battery pack include the secondary battery which has high capacity, high rate properties, and cycle properties, and thus, may be used as a power source of a medium-and-large sized device selected from the group consisting of an electric vehicle, a hybrid electric vehicle, a plug-in hybrid electric vehicle, and a power storage system.

Since the lithium secondary battery according to embodiments of the present invention stably exhibits excellent discharge capacity, output characteristics, and cycle performance, the lithium secondary battery may be used as a power source for portable devices such as mobile phones, notebook-sized computers and digital cameras, and medium-and-large sized devices selected from the group consisting of electric vehicles, hybrid electric vehicles, plug-in hybrid electric vehicles, and power storage systems. For example, the battery module or battery pack may be used as a power source for one or more medium-and-large sized devices of a power tool; an electric vehicle including an electric vehicle (EV), a hybrid electric vehicle and a plug-in hybrid electric vehicle (PHEV); and a power storage system.

Hereinafter, preferred embodiments will be suggested to facilitate understanding of the present invention, but the embodiments are only provided to illustrate the present invention, which fall within the accompanying claims.

## Example 1

A copper foil having a thickness of 10 $\mu$m was coated with a composition for forming a negative electrode active material layer, including a negative electrode active material including SiO and graphite (the weight ratio of SiO and graphite is a* and (100-a*), respectively), a conductive material (carbon black, CNT), a binder (SBR) and a thickener (CMC) at a weight ratio of 95.6 : 1.0 : 2.3 : 1.1 so as to have a dry thickness of 140 $\mu$m, and then dried to manufacture a negative electrode. Here, SiO had a particle diameter (D50) of 10 $\mu$m, and the size of Si crystalline was 20 nm. The above graphite comprises artificial graphite and natural graphite in a weight ratio of 7:3, and the average particle diameters (D50) of artificial graphite and natural graphite were 10 $\mu$m and 20 $\mu$m, respectively.

An aluminum foil having a thickness of 15 $\mu$m was coated with a composition for forming a positive electrode active material layer, including a lithium nickel-based oxide of $Li_{1.0}Ni_{0.86}Co_{0.06}Mn_{0.08}O_2$, a binder (PVDF) and a conductive material (CNT) at a weight ratio of 97 : 1 : 2 so as to have a dry thickness of 130 $\mu$m, and then dried to manufacture a positive electrode. Here, the particle size (D50) of the lithium nickel-based oxide was 20 $\mu$m and BET was 0.8 $m^2$/g.

The positive electrode and the negative electrode were stacked with a separator interposed therebetween, and an electrolyte solution was injected to manufacture a battery. A 12-$\mu$m thick separator provided with a coating layer including $Al_2O_3$ and PVDF binder on a PE/PP/PE triple structure base film was used, and as the electrolyte solution, 1 M $LiPF_6$, ethylene carbonate (EC)/ethyl methyl carbonate (EMC) (volume ratio 3/7), and vinylene carbonate (VC)/propanesultone (PS) (included in an amount of 3 parts by weight and 1.5 parts by weight, respectively, based on 100 parts by weight of the electrolyte) were used.

The values of the above-described Equation 1 for the manufactured batteries are shown in Table 1. In order to measure the room temperature service life and high temperature service life of the manufactured battery, the capacity retention rate during 200 cycles of charging and discharging under the following conditions is shown in the following Table 2.

* Room temperature service life: cycle was performed by constant current/constant voltage (CC/CV) charging (0.05 C-cut) and 0.5 C constant current (CC) discharging (2.5 V-cut) the manufactured cell to 4.2 V at 0.33 C C at room temperature (25°C).

* High temperature service life: cycle was performed by constant current/constant voltage (CC/CV) charging (0.05 C-cut) and 0.33 C constant current (CC) discharging (2.5 V-cut) the manufactured cell to 4.2 V at 0.33 C at high temperature (45°C).

* Quick charge life: cycled with Charge for 25 minutes from SOC (state of charge) 0% to 80%, and 0.33C C constant current (CC) discharge (2.5V-cut).

## Example 2

An experiment was performed in the same manner as in Example 1, except that a silicon carbon composite (Si/C) was used instead of SiO in the negative electrode active material. Here, the silicon carbon composite had a particle diameter (D50) of 10 $\mu$m, and the size of Si crystalline was 20 nm.

**Comparative Example 1**

An experiment was performed in the same manner as in Example 1, except that a lithium nickel-based oxide of $Li_{1.0}Ni_{0.84}Co_{0.08}Mn_{0.08}O_2$ was used instead of a lithium nickel-based oxide of $Li_{1.0}Ni_{0.86}Co_{0.06}Mn_{0.08}O_2$. Here, the particle size (D50) of the lithium nickel-based oxide was 10 $\mu$m and BET was 1.2 m$^2$/g.

**Comparative Example 2**

An experiment was performed in the same manner as in Example 1, except that a lithium nickel-based oxide of $Li_{1.0}Ni_{0.84}Co_{0.08}Mn_{0.08}O_2$ was used instead of a lithium nickel-based oxide of $Li_{1.0}Ni_{0.86}Co_{0.06}Mn_{0.08}O_2$ and a silicon carbon composite (Si/C) was used instead of SiO in the negative electrode active material. Here, the particle size (D50) of the lithium nickel-based oxide was 10 $\mu$m and BET was 1.2 m$^2$/g.

**Comparative Example 3**

An experiment was performed in the same manner as in Example 1, except that a lithium nickel-based oxide of $Li_{1.0}Ni_{0.84}Co_{0.08}Mn_{0.08}O_2$ was used instead of a lithium nickel-based oxide of $Li_{1.0}Ni_{0.86}Co_{0.06}Mn_{0.08}O_2$ and a weight ratio a* of SiO in the negative electrode active material was 3. Here, the particle size (D50) of the lithium nickel-based oxide was 10 $\mu$m and BET was 1.2 m$^2$/g.

[Table 1]

| | a | a* | b | c | Value of Equation 1 [(a x a*)+{b x (100-a*)}]/c |
|---|---|---|---|---|---|
| Example 1 | 75 | 6 | 93 | 88 | 104.5 |
| Example 2 | 80 | 6 | 93 | 88 | 104.8 |
| Comparative Example 1 | 75 | 6 | 93 | 90 | 102.1 |
| Comparative Example 2 | 80 | 6 | 93 | 90 | 102.5 |
| Comparative Example 3 | 75 | 3 | 93 | 90 | 102.7 |

[Table 2]

| | Experim ental Tempera ture (°C) | Number of cycles | Capacity retention rate (%) at room temperatu re and high temperatu re | Quick charge cycle | Quick charge Capacity retention rate |
|---|---|---|---|---|---|
| Example 1 | 25 | 200 | 95 | 50 | 97 |
| | 45 | 200 | 94 | - | - |
| Example 2 | 25 | 200 | 96 | 50 | 97 |
| | 45 | 200 | 94 | - | - |
| Comparative Example 1 | 25 | 200 | 80 | 50 | 85 |
| | 45 | 200 | 90 | - | - |
| Comparative Example 2 | 25 | 200 | 82 | 50 | 88 |
| | 45 | 200 | 92 | - | - |
| Comparative Example 3 | 25 | 200 | 85 | 50 | 88 |
| | 45 | 200 | 94 | - | - |

As shown in Table 2, it could be confirmed that the capacity retention rates after 200 cycles at room temperature and high temperature and after 50 cycles for quick charge in Examples 1 and 2 were excellent compared to that in Comparative Examples. The results illustrate that the batteries according to the invention are more sustainable due to their higher capacity retention rate after 200 cycles or 50 cycles.

**Claims**

1. A lithium secondary battery comprising: a positive electrode, a separator and a negative electrode,

wherein the positive electrode comprises a lithium composite transition metal compound comprising nickel (Ni) and cobalt (Co);
the negative electrode comprises a silicon-based active material and a carbon-based active material:

wherein a and b are respectively the efficiency constants of the silicon-based active material and the carbon-based active material; c is the efficiency constant of the lithium composite transition metal compound; a* represents the parts by weight of the silicon-based active material based on 100 parts by weight of the total amount of the silicon-based active material and the carbon-based active material,
wherein the lithium composite transition metal compound comprising nickel (Ni) and cobalt (Co) has an average particle diameter ($D_{50}$) of 12 $\mu$m to 30 $\mu$m, said average particle diameter ($D_{50}$) measured using a laser diffraction method; and a BET of 0.5 m2/g to 1.1 m$^2$/g;
wherein the silicon-based active material is included in an amount of 1 part by weight to 20 parts by weight based on 100 parts by weight of the total amount of the silicon-based active material and the carbon-based active material; and
wherein a, a*, b, and c satisfy the following Equation 1:

```
[Equation 1]
[(a x a*) + {b x (100-a*)}] / c > 103.5
```

and wherein
the efficiency constant a is defined as the percentage ratio of the discharge capacity to the charge capacity measured using a silicon-based active material as the negative electrode active material:

```
[discharge capacity(silicon-based)/charge capacity(silicon-based)*100];
```

the efficiency constant b is defined as the percentage ratio of the discharge capacity and charge capacity measured using a carbon-based active material as the negative electrode active material:

```
[discharge capacity(carbon-based)/charge capacity(carbon-based)*100];
```

and the efficiency constant c is defined as the percentage ratio of the discharge capacity and the charge capacity measured using a positive electrode active material as the active material:

```
[discharge capacity(nickel-cobalt-based)/charge capacity(nickel-cobalt-based)*100],
```

wherein discharge capacity and charge capacity are determined according to the method defined in the description, and wherein efficiency constant a is 70 to 85, efficiency constant b is 85 to 98, and efficiency constant c is 85 to 90.

2. The lithium secondary battery of claim 1, wherein the silicon-based active material is a silicon-carbon composite or silicon oxide, and the carbon-based active material is graphite.

3. The lithium secondary battery of claim 2, wherein the silicon carbon composite has a discharge efficiency of 85% to 95% measured as defined in the description using a constant current (CC) method at a rate of 0.2 C.

4. The lithium secondary battery of any of claims 2 or 3, wherein the average particle diameter ($D_{50}$) of the silicon-based composite particle is 2 $\mu$m to 15 $\mu$m, said average particle diameter ($D_{50}$) measured using a laser diffraction method.

5. The lithium secondary battery of any of claims 2 to 4, wherein the graphite includes both artificial graphite and natural graphite and the content ratio of artificial graphite to natural graphite is 5:5 to 9:1.

6. The lithium secondary battery of claims 5, wherein the average particle diameter ($D_{50}$) of artificial graphite is 5 μm to 20 μm, and the average particle diameter ($D_{50}$) of natural graphite is 5 μm to 30 μm, said average particle diameter ($D_{50}$) measured using a laser diffraction method.

7. The lithium secondary battery of any of claims 1 to 6, wherein the positive electrode comprises 90 parts by weight to 100 parts by weight of the lithium composite transition metal compound comprising nickel (Ni) and cobalt (Co) based on 100 parts by weight of the positive electrode active material.

8. The lithium secondary battery according to any of claims 1 to 7, wherein the lithium composite transition metal compound comprising nickel (Ni) and cobalt (Co) is represented by the following Chemical Formula 1:

[Chemical Formula 1] $\quad$ $Li_aNi_{(1-x-y)}Co_xM1_yM2_wO_2$

in Chemical Formula 1,

$1.0 \leq a \leq 1.5$, $0 \leq x \leq 0.2$, $0 \leq y \leq 0.2$, $0 \leq w \leq 0.1$, $0 \leq x+y \leq 0.2$,
M1 is at least one metal of Mn or Al, and
M2 is one or more metal elements selected from the group consisting of Ba, Ca, Zr, Ti, Mg, Ta, Nb and Mo.

9. The lithium secondary battery according to any of claims 1 to 8, wherein the lithium composite transition metal compound comprising nickel (Ni) and cobalt (Co) comprises 80 mol% or more of nickel referred to the total mols of nickel, cobalt and of any additional metal M of the lithium composite transition metal compound excluding lithium.

10. Method of manufacturing a secondary battery according to any of claims 1 to 8 comprising a positive electrode, a separator and a negative electrode, said method comprising:
applying a positive electrode active material layer comprising a lithium composite transition metal compound comprising nickel (Ni) and cobalt (Co) onto a positive electrode current collector to obtain a positive electrode, wherein the lithium composite transition metal compound comprising nickel (Ni) and cobalt (Co) has an average particle diameter ($D_{50}$) of 12 μm to 30 μm, said average particle diameter ($D_{50}$) measured using a laser diffraction method; and a BET of 0.5 m2/g to 1.1 m$^2$/g;

applying a negative electrode active material layer comprising a silicon-based active material and a carbon-based active material onto a negative electrode current collector to obtain a negative electrode, wherein the silicon-based active material is included in an amount of 1 part by weight to 20 parts by weight based on 100 parts by weight of the total amount of the silicon-based active material and the carbon-based active material;
drying and rolling the positive and negative electrodes;
stacking positive electrode and negative electrode were stacked a separator interposed therebetween;
wherein a and b are respectively the efficiency constants of the silicon-based active material and the carbon-based active material; c is the efficiency constant of the lithium composite transition metal compound; a* represents the parts by weight of the silicon-based active material based on 100 parts by weight of the total amount of the silicon-based active material and the carbon-based active material, and
wherein a, a*, b, and c satisfy the following Equation 1:

[Equation 1]

$$[(a \times a*) + \{b \times (100-a*)\}] / c > 103.5$$

and wherein
the efficiency constant a is defined as the percentage ratio of the discharge capacity to the charge capacity measured using a silicon-based active material as the negative electrode active material:

[discharge capacity$_{(silicon-based)}$/charge capacity$_{(silicon-based)}$*100];

the efficiency constant b is defined as the percentage ratio of the discharge capacity and charge capacity measured using a carbon-based active material as the negative electrode active material:

[discharge capacity$_{(carbon-based)}$/charge capacity$_{(carbon-based)}$*100];

and the efficiency constant c is defined as the percentage ratio of the discharge capacity and the charge capacity measured using a positive electrode active material as the active material:

$$[\texttt{discharge capacity}_{\texttt{(nickel-cobalt-based)}}/\texttt{charge capacity}_{\texttt{(nickel-cobalt-based)}}*100],$$

and wherein efficiency constant a is 70 to 85, efficiency constant b is 85 to 98, and efficiency constant c is 85 to 90.

11. A battery module including a lithium secondary battery according to any of claims 1 to 9.

12. A positive electrode slurry of a lithium secondary battery according to any of claims 1 to 9, the slurry comprising at least 90 parts by weight of a lithium composite transition metal compound comprising nickel (Ni) and cobalt (Co), based on 100 parts by weight of the positive electrode active material,

wherein the lithium composite transition metal compound comprising nickel (Ni) and cobalt (Co) is a particle with an average particle diameter ($D_{50}$) of 12 $\mu$m to 30 $\mu$m and a BET of 0.5 m2/g to 1.1 $m^2/g$, and with an efficiency constant c of 85 to 90; said average particle diameter ($D_{50}$) measured using a laser diffraction method; wherein
the efficiency constant c is defined as the percentage ratio of the discharge capacity and the charge capacity measured using a positive electrode active material as the active material:

[discharge capacity$_{(nickel-cobalt-based)}$/charge capacity$_{(nickel-cobalt-based)}$*100] .

13. A negative electrode slurry of a lithium secondary battery according to any of claims 1 to 9, the slurry comprising at least 1 part by weight to 20 part by weight of a silicon-based active material and at least 80 parts by weight of a carbon-based active material, based on 100 parts by weight of the negative electrode active material; wherein

the silicon-based active material is a silicon-carbon composite or silicon oxide with an efficiency constant a of 70 to 85, and the carbon-based active material is a graphite with an efficiency constant b of 85 to 98; the graphite including both artificial graphite and natural graphite in a ratio of artificial graphite to natural graphite of 5:5 to 9:1; and wherein the average particle diameter ($D_{50}$) of artificial graphite is 5 $\mu$m to 20 $\mu$m, and the average particle diameter ($D_{50}$) of natural graphite is 5 $\mu$m to 30 $\mu$m; said average particle diameter ($D_{50}$) measured using a laser diffraction method;
and wherein
the efficiency constant a is defined as the percentage ratio of the discharge capacity to the charge capacity measured using a silicon-based active material as the negative electrode active material:

$$[\texttt{discharge capacity}_{\texttt{(silicon-based)}}/\texttt{charge capacity}_{\texttt{(silicon-based)}}*100];$$

and the efficiency constant b is defined as the percentage ratio of the discharge capacity and charge capacity measured using a carbon-based active material as the negative electrode active material:

$$[\texttt{discharge capacity}_{\texttt{(carbon-based)}}/\texttt{charge capacity}_{\texttt{(carbon-based)}}*100].$$

**Patentansprüche**

1. Lithium-Sekundärbatterie, umfassend: eine positive Elektrode, einen Separator und eine negative Elektrode,

wobei die positive Elektrode eine Lithium-Übergangsmetall-Kompositverbindung umfasst, die Nickel (Ni) und Cobalt (Co) umfasst;
die negative Elektrode ein siliziumbasiertes Aktivmaterial und ein kohlenstoffbasiertes Aktivmaterial umfasst:

wobei a und b jeweils die Wirkungsgradkonstanten des siliziumbasierten Aktivmaterials und des kohlenstoffbasierten Aktivmaterials sind; c die Wirkungsgradkonstante der Lithium-Übergangsmetall-Kompositverbindung ist; a* die Gewichtsteile des siliziumbasierten Aktivmaterials bezogen auf 100 Gewichtsteile der Gesamtmenge des siliziumbasierten Aktivmaterials und des kohlenstoffbasierten Aktivmaterials darstellt, wobei die Lithium-Übergangsmetall-Kompositverbindung, die Nickel (Ni) und Cobalt (Co) umfasst, einen mittleren Partikeldurchmesser ($D_{50}$) von 12 $\mu$m bis 30 $\mu$m aufweist, wobei der mittlere Partikeldurchmesser ($D_{50}$) unter Verwendung eines Laserbeugungsverfahrens gemessen wird; und eine BET von 0,5 m$^2$/g bis 1,1 m$^2$/g aufweist;

wobei das siliziumbasierte Aktivmaterial in einer Menge von 1 Gewichtsteil bis 20 Gewichtsteilen, bezogen auf 100 Gewichtsteile der Gesamtmenge des siliziumbasierten Aktivmaterials und des kohlenstoffbasierten Aktivmaterials, enthalten ist; und

wobei a, a*, b und c die folgende Gleichung 1 erfüllen:

[Gleichung 1]

$$[(a \times a^*) + \{b \times (100 - a^*)\}]/c > 103{,}5$$

und wobei

die Wirkungsgradkonstante a als das prozentuale Verhältnis der Entladekapazität zur Ladekapazität definiert ist, gemessen unter Verwendung eines siliziumbasierten Aktivmaterials als negatives Elektrodenaktivmaterial:

$$[\text{Entladekapazität}_{(\text{siliziumbasiert})}/\text{Ladekapazität}_{(\text{siliziumbasiert})} *100];$$

die Wirkungsgradkonstante b als das prozentuale Verhältnis der Entladekapazität und der Ladekapazität definiert ist, gemessen unter Verwendung eines kohlenstoffbasierten Aktivmaterials als negatives Elektrodenaktivmaterial:

$$[\text{Entladekapazität}_{(\text{kohlenstoffbasiert})}/\text{Ladekapazität}_{(\text{kohlenstoffbasiert})} *100];$$

und die Wirkungsgradkonstante c als das prozentuale Verhältnis der Entladekapazität und der Ladekapazität definiert ist, gemessen unter Verwendung eines positiven Elektrodenaktivmaterials als Aktivmaterial:

$$[\text{Entladekapazität}_{(\text{nickel-cobalt-basiert})}/\text{Ladekapazität}_{(\text{nickel-cobalt-basiert})} *100],$$

wobei Entladekapazität und Ladekapazität gemäß dem in der Beschreibung definierten Verfahren bestimmt werden, und

wobei die Wirkungsgradkonstante a 70 bis 85 beträgt, die Wirkungsgradkonstante b 85 bis 98 beträgt und die Wirkungsgradkonstante c 85 bis 90 beträgt.

2. Lithium-Sekundärbatterie nach Anspruch 1, wobei das siliziumbasierte Aktivmaterial ein Silizium-Kohlenstoff-Komposit oder Siliziumoxid ist, und das kohlenstoffbasierte Aktivmaterial Graphit ist.

3. Lithium-Sekundärbatterie nach Anspruch 2, wobei der Silizium-Kohlenstoff-Komposit einen Entladewirkungsgrad von 85 % bis 95 % aufweist, gemessen wie in der Beschreibung definiert unter Verwendung eines Konstantstromverfahrens (CC) mit einer Rate von 0,2 C.

4. Lithium-Sekundärbatterie nach einem der Ansprüche 2 oder 3, wobei der mittlere Partikeldurchmesser ($D_{50}$) des siliziumbasierten Komposits 2 $\mu$m bis 15 $\mu$m beträgt, wobei der mittlere Partikeldurchmesser ($D_{50}$) unter Verwendung eines Laserbeugungsverfahrens gemessen wird.

5. Lithium-Sekundärbatterie nach einem der Ansprüche 2 bis 4, wobei der Graphit sowohl künstlichen Graphit als auch natürlichen Graphit enthält und das Gehaltsverhältnis von künstlichem Graphit zu natürlichem Graphit 5:5 bis 9:1 beträgt.

6. Lithium-Sekundärbatterie nach Anspruch 5, wobei der mittlere Partikeldurchmesser ($D_{50}$) von künstlichem Graphit 5 $\mu$m bis 20 $\mu$m beträgt und der mittlere Partikeldurchmesser ($D_{50}$) von natürlichem Graphit 5 $\mu$m bis 30 $\mu$m beträgt,

wobei der mittlere Partikeldurchmesser ($D_{50}$) unter Verwendung eines Laserbeugungsverfahrens gemessen wird.

7. Lithium-Sekundärbatterie nach einem der Ansprüche 1 bis 6, wobei die positive Elektrode 90 Gewichtsteile bis 100 Gewichtsteile der Lithium-Übergangsmetall-Kompositverbindung, die Nickel (Ni) und Cobalt (Co) umfasst, bezogen auf 100 Gewichtsteile des positiven Elektrodenaktivmaterials, umfasst.

8. Lithium-Sekundärbatterie nach einem der Ansprüche 1 bis 7, wobei die Lithium-Übergangsmetall-Kompositverbindung, die Nickel (Ni) und Cobalt (Co) umfasst, durch die folgende Chemische Formel 1 dargestellt wird:

$$[\text{Chemische Formel 1}] \qquad Li_aNi_{(1-x-y)}Co_xM1_yM2_wO_2$$

in Chemischer Formel 1,

$1{,}0 \leq a \leq 1{,}5$, $0 \leq x \leq 0{,}2$, $0 \leq y \leq 0{,}2$, $0 \leq w \leq 0{,}1$, $0 \leq x+y \leq 0{,}2$,
M1 ist mindestens ein Metall aus Mn oder Al, und
M2 ist ein oder mehrere Metallelemente, ausgewählt aus der Gruppe bestehend aus Ba, Ca, Zr, Ti, Mg, Ta, Nb und Mo.

9. Lithium-Sekundärbatterie nach einem der Ansprüche 1 bis 8, wobei die Lithium-Übergangsmetall-Kompositverbindung, die Nickel (Ni) und Cobalt (Co) umfasst, 80 Mol-% oder mehr Nickel, bezogen auf die Gesamtmolzahl von Nickel, Cobalt und jeglichem zusätzlichen Metall M der Lithium-Übergangsmetall-Kompositverbindung außer Lithium, umfasst.

10. Verfahren zur Herstellung einer Sekundärbatterie nach einem der Ansprüche 1 bis 8, umfassend eine positive Elektrode, einen Separator und eine negative Elektrode, wobei das Verfahren umfasst:

Aufbringen einer Aktivmaterialschicht der positiven Elektrode, die eine Lithium-Übergangsmetall-Kompositverbindung umfasst, die Nickel (Ni) und Cobalt (Co) umfasst, auf einen Stromkollektor der positiven Elektrode, um eine positive Elektrode zu erhalten,
wobei die Lithium-Übergangsmetall-Kompositverbindung, die Nickel (Ni) und Cobalt (Co) umfasst, einen mittleren Partikeldurchmesser ($D_{50}$) von 12 $\mu$m bis 30 $\mu$m aufweist, wobei der mittlere Partikeldurchmesser ($D_{50}$) unter Verwendung eines Laserbeugungsverfahrens gemessen wird; und eine BET von 0,5 m$^2$/g bis 1,1 m$^2$/g aufweist;
Aufbringen einer Aktivmaterialschicht der negativen Elektrode, die ein siliziumbasiertes Aktivmaterial und ein kohlenstoffbasiertes Aktivmaterial umfasst, auf einen Stromkollektor der negativen Elektrode, um eine negative Elektrode zu erhalten, wobei das siliziumbasierte Aktivmaterial in einer Menge von 1 Gewichtsteil bis 20 Gewichtsteilen, bezogen auf 100 Gewichtsteile der Gesamtmenge des siliziumbasierten Aktivmaterials und des kohlenstoffbasierten Aktivmaterials, enthalten ist;
Trocknen und Walzen der positiven und negativen Elektroden;
Stapeln der positiven Elektrode und der negativen Elektrode, wobei ein Separator dazwischen angeordnet wurde;
wobei a und b jeweils die Wirkungsgradkonstanten des siliziumbasierten Aktivmaterials und des kohlenstoffbasierten Aktivmaterials sind; c die Wirkungsgradkonstante der Lithium-Übergangsmetall-Kompositverbindung ist; a* die Gewichtsteile des siliziumbasierten Aktivmaterials bezogen auf 100 Gewichtsteile der Gesamtmenge des siliziumbasierten Aktivmaterials und des kohlenstoffbasierten Aktivmaterials darstellt, und
wobei a, a*, b und c die folgende Gleichung 1 erfüllen:

[Gleichung 1]

$$[(a \times a^*) + \{b \times (100 - a^*)\}]/c > 103{,}5$$

und wobei
die Wirkungsgradkonstante a als das prozentuale Verhältnis der Entladekapazität zur Ladekapazität definiert ist, gemessen unter Verwendung eines siliziumbasierten Aktivmaterials als negatives Elektrodenaktivmaterial:

$$[\text{Entladekapazität}_{(\text{siliziumbasiert})}/\text{Ladekapazität}_{(\text{siliziumbasiert})} *100];$$

die Wirkungsgradkonstante b als das prozentuale Verhältnis der Entladekapazität und der Ladekapazität definiert ist, gemessen unter Verwendung eines kohlenstoffbasierten Aktivmaterials als negatives Elektrodenaktivmaterial:

$$[Entladekapazität_{(kohlenstoffbasiert)}/Ladekapazität_{(kohlenstoffbasiert)} *100];$$

und die Wirkungsgradkonstante c als das prozentuale Verhältnis der Entladekapazität und der Ladekapazität definiert ist, gemessen unter Verwendung eines positiven Elektrodenaktivmaterials als Aktivmaterial:

$$[Entladekapazität_{(nickel-cobalt-basiert)}/Ladekapazität_{(nickel-cobalt-basiert)} *100],$$

und
wobei die Wirkungsgradkonstante a 70 bis 85 beträgt, die Wirkungsgradkonstante b 85 bis 98 beträgt und die Wirkungsgradkonstante c 85 bis 90 beträgt.

11. Ein Batteriemodul, das eine Lithium-Sekundärbatterie nach einem der Ansprüche 1 bis 9 enthält.

12. Eine Aufschlämmung für die positive Elektrode einer Lithium-Sekundärbatterie nach einem der Ansprüche 1 bis 9, wobei die Aufschlämmung mindestens 90 Gewichtsteile einer Lithium-Übergangsmetall-Kompositverbindung, die Nickel (Ni) und Cobalt (Co) umfasst, bezogen auf 100 Gewichtsteile des positiven Elektrodenaktivmaterials, umfasst,

wobei die Lithium-Übergangsmetall-Kompositverbindung, die Nickel (Ni) und Cobalt (Co) umfasst, ein Partikel mit einem mittleren Partikeldurchmesser ($D_{50}$) von 12 $\mu$m bis 30 $\mu$m und einer BET von 0,5 m$^2$/g bis 1,1 m$^2$/g und mit einer Wirkungsgrad konstante c von 85 bis 90 ist; wobei der mittlere Partikeldurchmesser ($D_{50}$) unter Verwendung eines Laserbeugungsverfahrens gemessen wird;
wobei die Wirkungsgradkonstante c als das prozentuale Verhältnis der Entladekapazität und der Ladekapazität definiert ist, gemessen unter Verwendung eines positiven Elektrodenaktivmaterials als Aktivmaterial:

$$[Entladekapazität_{(nickel-cobalt-basiert)}/Ladekapazität_{(nickel-cobalt-basiert)} *100].$$

13. Eine Aufschlämmung für die negative Elektrode einer Lithium-Sekundärbatterie nach einem der Ansprüche 1 bis 9, wobei die Aufschlämmung mindestens 1 Gewichtsteil bis 20 Gewichtsteile eines siliziumbasierten Aktivmaterials und mindestens 80 Gewichtsteile eines kohlenstoffbasierten Aktivmaterials, bezogen auf 100 Gewichtsteile des negativen Elektrodenaktivmaterials, umfasst;

wobei das siliziumbasierte Aktivmaterial ein Silizium-Kohlenstoff-Komposit oder Siliziumoxid mit einer Wirkungsgrad konstante a von 70 bis 85 ist und das kohlenstoffbasierte Aktivmaterial ein Graphit mit einer Wirkungsgradkonstante b von 85 bis 98 ist; wobei der Graphit sowohl künstlichen Graphit als auch natürlichen Graphit in einem Verhältnis von künstlichem Graphit zu natürlichem Graphit von 5:5 bis 9:1 enthält; und wobei der mittlere Partikeldurchmesser ($D_{50}$)von künstlichem Graphit 5 $\mu$m bis 20 $\mu$m beträgt und der mittlere Partikeldurchmesser ($D_{50}$) von natürlichem Graphit 5 $\mu$m bis 30 $\mu$m beträgt; wobei der mittlere Partikeldurchmesser ($D_{50}$) unter Verwendung eines Laserbeugungsverfahrens gemessen wird;
und wobei
die Wirkungsgradkonstante a als das prozentuale Verhältnis der Entladekapazität zur Ladekapazität definiert ist, gemessen unter Verwendung eines siliziumbasierten Aktivmaterials als negatives Elektrodenaktivmaterial:

$$[Entladekapazität_{(siliziumbasiert)}/Ladekapazität_{(siliziumbasiert)} *100];$$

und die Wirkungsgradkonstante b als das prozentuale Verhältnis der Entladekapazität und der Ladekapazität definiert ist, gemessen unter Verwendung eines kohlenstoffbasierten Aktivmaterials als negatives Elektrodenaktivmaterial:

$$[Entladekapazität_{(kohlenstoffbasiert)}/Ladekapazität_{(kohlenstoffbasiert)} *100].$$

**Revendications**

1. Batterie secondaire au lithium comprenant : une électrode positive, un séparateur et une électrode négative,

dans laquelle l'électrode positive comprend un composé de métal de transition composite au lithium comprenant du nickel (Ni) et du cobalt (Co) ;
l'électrode négative comprend un matériau actif à base de silicium et un matériau actif à base de carbone :

dans laquelle a et b sont respectivement les constantes d'efficacité du matériau actif à base de silicium et du matériau actif à base de carbone ; c est la constante d'efficacité du composé de métal de transition composite au lithium ; a* représente les parties en poids du matériau actif à base de silicium sur la base de 100 parties en poids de la quantité totale du matériau actif à base de silicium et du matériau actif à base de carbone,
dans laquelle le composé de métal de transition composite au lithium comprenant du nickel (Ni) et du cobalt (Co) a un diamètre moyen des particules ($D_{50}$) de 12 $\mu$m à 30 $\mu$m, ledit diamètre moyen des particules ($D_{50}$) étant mesuré en utilisant une méthode de diffraction laser ; et une BET de 0,5 m$^2$/g à 1,1 m$^2$/g;
dans laquelle le matériau actif à base de silicium est inclus en une quantité de 1 partie en poids à 20 parties en poids sur la base de 100 parties en poids de la quantité totale du matériau actif à base de silicium et du matériau actif à base de carbone ; et
dans laquelle a, a*, b et c satisfont à l'équation 1 suivante :

[Équation 1]

$$[(a \times a^*) + \{b \times (100 - a^*)\}]/c > 103.5$$

et dans laquelle
la constante d'efficacité a est définie comme le rapport en pourcentage de la capacité de décharge à la capacité de charge mesurée en utilisant un matériau actif à base de silicium comme matériau actif d'électrode négative :

[capacité de décharge$_{(\text{à base de silicium})}$/capacité de charge$_{(\text{à base de silicium})}$ *100] ;

la constante d'efficacité b est définie comme le rapport en pourcentage de la capacité de décharge et de la capacité de charge mesurée en utilisant un matériau actif à base de carbone comme matériau actif d'électrode négative :

[capacité de décharge$_{(\text{à base de carbone})}$/capacité de charge$_{(\text{à base de carbone})}$ *100] ;

et la constante d'efficacité c est définie comme le rapport en pourcentage de la capacité de décharge et de la capacité de charge mesurée en utilisant un matériau actif d'électrode positive comme matériau actif :

[capacité de décharge$_{(\text{à base de nickel-cobalt})}$/capacité de charge$_{(\text{à base de nickel-cobalt})}$ *100],

dans laquelle la capacité de décharge et la capacité de charge sont déterminées selon la méthode définie dans la description, et
dans laquelle la constante d'efficacité a est de 70 à 85, la d'efficacité b est de 85 à 98, et la d'efficacité c est de 85 à 90.

2. La batterie secondaire au lithium selon la revendication 1, dans laquelle le matériau actif à base de silicium est un composite silicium-carbone ou un oxyde de silicium, et le matériau actif à base de carbone est du graphite.

3. La batterie secondaire au lithium selon la revendication 2, dans laquelle le composite silicium-carbone a un rendement de décharge de 85 % à 95 % mesuré comme défini dans la description en utilisant une méthode à courant constant (CC) à un taux de 0,2 C.

4. La batterie secondaire au lithium selon l'une quelconque des revendications 2 ou 3, dans laquelle le diamètre moyen des particules ($D_{50}$) de la particule de composite à base de silicium est de 2 $\mu$m à 15 $\mu$m, ledit diamètre moyen des

particules ($D_{50}$) étant mesuré en utilisant une méthode de diffraction laser.

5. La batterie secondaire au lithium selon l'une quelconque des revendications 2 à 4, dans laquelle le graphite inclut à la fois du graphite artificiel et du graphite naturel et le rapport de contenu du graphite artificiel au graphite naturel est de 5:5 à 9:1.

6. La batterie secondaire au lithium selon la revendication 5, dans laquelle le diamètre moyen des particules ($D_{50}$) du graphite artificiel est de 5 $\mu$m à 20 $\mu$m, et le diamètre moyen des particules ($D_{50}$) du graphite naturel est de 5 $\mu$m à 30 $\mu$m, ledit diamètre moyen des particules ($D_{50}$) étant mesuré en utilisant une méthode de diffraction laser.

7. La batterie secondaire au lithium selon l'une quelconque des revendications 1 à 6, dans laquelle l'électrode positive comprend de 90 parties en poids à 100 parties en poids du composé de métal de transition composite au lithium comprenant du nickel (Ni) et du cobalt (Co) sur la base de 100 parties en poids du matériau actif d'électrode positive.

8. La batterie secondaire au lithium selon l'une quelconque des revendications 1 à 7, dans laquelle le composé de métal de transition composite au lithium comprenant du nickel (Ni) et du cobalt (Co) est représenté par la formule chimique 1 suivante :

[Formule Chimique 1]     $Li_aNi_{(1-x-y)}Co_xM1_yM2_wO_2$

dans la formule chimique 1,

$1{,}0 \leq a \leq 1{,}5$, $0 \leq x \leq 0{,}2$, $0 \leq y \leq 0{,}2$, $0 \leq w \leq 0{,}1$, $0 \leq x+y \leq 0{,}2$,
M1 est au moins un métal parmi Mn ou Al, et
M2 est un ou plusieurs éléments métalliques choisis dans le groupe constitué de Ba, Ca, Zr, Ti, Mg, Ta, Nb et Mo.

9. La batterie secondaire au lithium selon l'une quelconque des revendications 1 à 8, dans laquelle le composé de métal de transition composite au lithium comprenant du nickel (Ni) et du cobalt (Co) comprend 80 % en moles ou plus de nickel par rapport au nombre total de moles de nickel, de cobalt et de tout métal M supplémentaire du composé de métal de transition composite au lithium, à l'exclusion du lithium.

10. Procédé de fabrication d'une batterie secondaire selon l'une quelconque des revendications 1 à 8, comprenant une électrode positive, un séparateur et une électrode négative, ledit procédé comprenant :

l'application d'une couche de matériau actif d'électrode positive comprenant un composé de métal de transition composite au lithium comprenant du nickel (Ni) et du cobalt (Co) sur un collecteur de courant d'électrode positive pour obtenir une électrode positive,
dans lequel le composé de métal de transition composite au lithium comprenant du nickel (Ni) et du cobalt (Co) a un diamètre moyen des particules ($D_{50}$) de 12 $\mu$m à 30 $\mu$m, ledit diamètre moyen des particules ($D_{50}$) étant mesuré en utilisant une méthode de diffraction laser ; et une BET de 0,5 m$^2$/g à 1,1 m$^2$/g ;
l'application d'une couche de matériau actif d'électrode négative comprenant un matériau actif à base de silicium et un matériau actif à base de carbone sur un collecteur de courant d'électrode négative pour obtenir une électrode négative, dans laquelle le matériau actif à base de silicium est inclus en une quantité de 1 partie en poids à 20 parties en poids sur la base de 100 parties en poids de la quantité totale du matériau actif à base de silicium et du matériau actif à base de carbone ;
le séchage et le laminage des électrodes positive et négative;
l'empilement de l'électrode positive et de l'électrode négative, un séparateur étant interposé entre elles ;
dans lequel a et b sont respectivement les constantes d'efficacité du matériau actif à base de silicium et du matériau actif à base de carbone ; c est la constante d'efficacité du composé de métal de transition composite au lithium ; a* représente les parties en poids du matériau actif à base de silicium sur la base de 100 parties en poids de la quantité totale du matériau actif à base de silicium et du matériau actif à base de carbone, et
dans lequel a, a*, b et c satisfont à l'équation 1 suivante :

[Équation 1]

$$[(a \times a^*) + \{b \times (100 - a^*)\}]/c > 103.5$$

et dans lequel

la constante d'efficacité a est définie comme le rapport en pourcentage de la capacité de décharge à la capacité de charge mesurée en utilisant un matériau actif à base de silicium comme matériau actif d'électrode négative :

$$[\text{capacité de décharge}_{(\text{à base de silicium})}/\text{capacité de charge}_{(\text{à base de silicium})} * 100] \ ;$$

la constante d'efficacité b est définie comme le rapport en pourcentage de la capacité de décharge et de la capacité de charge mesurée en utilisant un matériau actif à base de carbone comme matériau actif d'électrode négative :

$$[\text{capacité de décharge}_{(\text{à base de carbone})}/\text{capacité de charge}_{(\text{à base de carbone})} * 100] \ ;$$

et la constante d'efficacité c est définie comme le rapport en pourcentage de la capacité de décharge et de la capacité de charge mesurée en utilisant un matériau actif d'électrode positive comme matériau actif :

$$[\text{capacité de décharge}_{(\text{à base de nickel-cobalt})}/\text{capacité de charge}_{(\text{à base de nickel-cobalt})} * 100], \ et$$

dans lequel la constante d'efficacité a est de 70 à 85, la constante d'efficacité b est de 85 à 98, et la constante d'efficacité c est de 85 à 90.

11. Un module de batterie incluant une batterie secondaire au lithium selon l'une quelconque des revendications 1 à 9.

12. Une suspension d'électrode positive d'une batterie secondaire au lithium selon l'une quelconque des revendications 1 à 9, la suspension comprenant au moins 90 parties en poids d'un composé de métal de transition composite au lithium comprenant du nickel (Ni) et du cobalt (Co), sur la base de 100 parties en poids du matériau actif d'électrode positive,

dans laquelle le composé de métal de transition composite au lithium comprenant du nickel (Ni) et du cobalt (Co) est une particule avec un diamètre moyen des particules ($D_{50}$) de 12 $\mu$m à 30 $\mu$m et une BET de 0,5 m$^2$/g à 1,1 m$^2$/g, et avec une constante d'efficacité c de 85 à 90 ; ledit diamètre moyen des particules ($D_{50}$) étant mesuré en utilisant une méthode de diffraction laser ;

dans laquelle la constante d'efficacité c est définie comme le rapport en pourcentage de la capacité de décharge et de la capacité de charge mesurée en utilisant un matériau actif d'électrode positive comme matériau actif :

$$[\text{capacité de décharge}_{(\text{à base de nickel-cobalt})}/\text{capacité de charge}_{(\text{à base de nickel-cobalt})} * 100].$$

13. Une suspension d'électrode négative d'une batterie secondaire au lithium selon l'une quelconque des revendications 1 à 9, la suspension comprenant au moins 1 partie en poids à 20 parties en poids d'un matériau actif à base de silicium et au moins 80 parties en poids d'un matériau actif à base de carbone, sur la base de 100 parties en poids du matériau actif d'électrode négative ;

dans laquelle le matériau actif à base de silicium est un composite silicium-carbone ou un oxyde de silicium avec une constante d'efficacité a de 70 à 85, et le matériau actif à base de carbone est un graphite avec une constante d'efficacité b de 85 à 98 ; le graphite incluant à la fois du graphite artificiel et du graphite naturel dans un rapport du graphite artificiel au graphite naturel de 5:5 à 9:1 ; et dans laquelle le diamètre moyen des particules ($D_{50}$) du graphite artificiel est de 5 $\mu$m à 20 $\mu$m, et le diamètre moyen des particules ($D_{50}$) du graphite naturel est de 5 $\mu$m à 30 $\mu$m ; ledit diamètre moyen des particules ($D_{50}$)étant mesuré en utilisant une méthode de diffraction laser ; et dans laquelle

la constante d'efficacité a est définie comme le rapport en pourcentage de la capacité de décharge à la capacité de charge mesurée en utilisant un matériau actif à base de silicium comme matériau actif d'électrode négative :

$$[\text{capacité de décharge}_{(\text{à base de silicium})}/\text{capacité de charge}_{(\text{à base de silicium})} * 100] \ ;$$

et la constante d'efficacité b est définie comme le rapport en pourcentage de la capacité de décharge et de la capacité de charge mesurée en utilisant un matériau actif à base de carbone comme matériau actif d'électrode

négative :

$$[\text{capacité de décharge}_{(\text{à base de carbone})}/\text{capacité de charge}_{(\text{à base de carbone})} *100].$$

$$[\text{capacité de décharge}_{(\text{à base de carbone})}/\text{capacité de charge}_{(\text{à base de carbone})} *100].$$

**EP 4 354 528 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2021013493 A1
- JP 6676289 B
- US 2029036117 A1
- US 2016197340 A1